Europäisches Patentamt

European Patent Office

Office européen des brevets

(19)

(11) **EP 0 561 054 B1**

## (12) EUROPÄISCHE PATENTSCHRIFT

(45) Veröffentlichungstag und Bekanntmachung des Hinweises auf die Patenterteilung:
**01.04.1998  Patentblatt 1998/14**

(51) Int Cl.6: **G01R 27/26**, G01D 5/24, G01D 5/20

(21) Anmeldenummer: **92120967.2**

(22) Anmeldetag: **09.12.1992**

(54) **Verfahren und Messvorrichtung zur Messung der Zeitkonstanten eines elektrischen Wegaufnehmers**

Apparatus and procedure for measuring the time-constant of an electrical displacement transducer

Appareil et procédé pour mesurer la constante de temps d'un capteur de déplacement

(84) Benannte Vertragsstaaten:
**AT DE FR GB IT NL SE**

(30) Priorität: **16.03.1992  DE 4208399**

(43) Veröffentlichungstag der Anmeldung:
**22.09.1993  Patentblatt 1993/38**

(73) Patentinhaber: **KNORR-BREMSE Systeme für Nutzfahrzeuge GmbH
80809 München (DE)**

(72) Erfinder:
- **Gschossmann, Günther
  W-8260 Mühldorf (DE)**
- **Wolf, Josef
  W-8062 Markt Indersdorf (DE)**

(74) Vertreter: **von Bülow, Tam, Dr.
Patentanwaltskanzlei
Mailänder Strasse 13
81545 München (DE)**

(56) Entgegenhaltungen:
**WO-A-85/01356        DE-A- 2 833 141
DE-A- 3 343 885        GB-A- 2 097 941
US-A- 3 824 459        US-A- 4 633 168
US-A- 5 021 740**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die vorliegende Erfindung bezieht sich auf ein Verfahren und eine Meßvorrichtung zur Messung der Zeitkonstanten eines elektrischen Wegaufnehmers gemäß dem Oberbegriff des Anspruchs 1 und 10, wobei insbesondere der Meßkreis ein sogenannter Wegaufnehmer ist, der sowohl aus einer Kapazität als auch aus eine Induktivität gebildet sein kann.

Derartige Meßvorrichtungen sind aus der EP -A-0 358 241 und aus der DE-OS 37 14 993 bekannt. In der letztgenannten Druckschrift wird eine Vorrichtung zur Auswertung von Signalen eines Wegaufnehmers vorgeschlagen. Ein Wegaufnehmer besteht im allgemeinen aus einer Induktivität, in die ein Eisenkern beweglich eintaucht, um damit die Induktivtität der Spule zu verändern. Im Falle der DE 37 14 993 ist die Induktivität Bestandteil einer Wheatstonschen Brücke, bei der die Induktivität mittels eines Schalters in den einen Brückenzweig eingeschaltet wird. Die Brückenschaltung wird von einem Komparator überwacht und ein Mikrocomputer erfaßt die Zeit zwischen der Betätigung des Schalters und dem Null-Durchgang der Brückenspannung. Nachteilig an einer solchen Schaltungsanordung sind die in solchen Schaltungen auftretenden Potentiale, welche in Fahrzeugen eine große Störempfindlichkeit bewirken.

Die weiterhin bekannte Vorrichtung (EP 0 358 241 A2) sieht ebenfalls als Sensor bzw. Wegaufnehmer einer Induktivität vor, in der ein Eisenkern verschieblich angeordnet ist. Die Auswertelektronik enthält einen Mikrocomputer, der die Induktivität mit einem Spannungsstoß anregt und mit dem resultierenden Ladestrom eine Zeitmessung durchführt, die direkt proportional der zu messenden Induktivität ist. An dieser Auswertelektronik wird als nachteilig empfunden, den resultierenden Strom als bestimmende Größe zu verwenden, da Ströme im allgemeinen aufwendiger zu handhaben sind, um eine genaue Bestimmung zu erzielen.

Ferner ist es im Stand der Technik bekannt, aus der verhältnismäßig genau zu bestimmenden Frequenz die veränderliche Iduktivität bzw. Kapazität zu messen. Bei dieser Methode ist es jedoch nachteilig, daß die zu bestimmenden Größen nicht linear von der gemessenen Frequenz abhängig sind, so daß hierdurch systematische Fehler unvermeidlich sind. Daher ist es sinnvoll, eine lineare Meßgröße zu erfassen. Hier bietet sich die Methode der Zeitkonstantenmessung an, bei der in Abhängigkeit von der Induktivität oder der Kapazität die Zeitkonstante (T) gemessen wird.

Die oben erwähnte Druckschrift EP 0358 241 A2 arbeitet nach diesem Prinzip. Allerdings wird bei dieser bekannten Methode als nachteilig empfunden, daß der ohmsche Widerstand der Spule des Wegaufnehmers konstant oder verhältnismäßig niederohmig sein muß, was für eine ausreichende Induktivität nicht ohne weiteres zu erzielen ist.

Daher ist es Aufgabe der vorliegenden Erfindung, ein Verfahren und eine Vorrichtung bereitzustellen, die die o.g. Nachteile beseitigen und in denen eine lineare Meßgröße aufgenommen wird, bei der eine Änderung der Versorgungsspannung und des ohmschen Widerstandes des Wegaufnehmers durch äußere Einwirkung keinen Einfluß hat.

Diese Aufgabe wird erfindungsgemäß entsprechend dem Oberbegriff des Anspruchs 1 und 10 mit den kennzeichnenden Merkmalen dieser Ansprüche gelöst.

Dabei erweist es sich als äußert vorteilhaft, einen ersten und einen zweiten steuerbaren Schalter zu verwenden, die in einem vorbestimmten Zeittakt geschaltet werden, wobei sich der Takt aus den Schwellenspannungen am Wegaufnehmer und an der konstanten Vergleichskapazität ergibt. Obwohl die vorliegende Erfindung vorzugsweise mit einer Induktivität als Wegaufnehmer ausgestattet ist, kann vorteilhafterweise ebenfalls ein kapazitiver Wegaufnehmer verwendet werden, ohne daß das erfindungsgemäße Meßverfahren geändert wird.

Erfindungsgemäß ist die Zeitkonstante der Kombination aus dem konstanten Vergleichskondensator und dem dazu gehörigen Spannungsteiler sehr viel größer zu wählen als die Zeitkonstante des Wegaufnehmers. Durch diese Maßnahme bleibt die Schwellenspannung ($U_B$) am Vergleichskondensator so lange erhalten, bis ein neuer Meßzyklus durch Einschalten des ersten Schalters, der den Wegaufnehmer einschaltet, eingeleitet wird.

Vorteilhaft wirkt sich auch die Maßnahme aus, den Komparator mit einer Hysterese so zu beschalten, daß die Hysterese das Abschalten des Komparators beschleunigt und Störungen auf dem Meßsignal unterdrückt, d.h., den Ausgang des Komparators mit dem positiven Eingang des Komparators über einen Widerstand zu verbinden.

Die Verwendung eines Mikrocomputers ist für die vorliegende Erfindung vorteilhaft, jedoch nicht zwingend, so daß ebenso diskrete Bauteile verwendet werden können, die einen Mikrocomputer in bestimmten Fällem ersetzen, wodurch unter Umständen die gesamte Schaltung kostengünstiger auszulegen ist.

Weitere vorteilhafte Ausgestaltungen ergeben sich aus den Unteransprüchen.

Im folgenden wird anhand der Zeichnungen die Erfindung näher erläutert. Es zeigt

Fig.1a      ein Prinzipschaltbild einer Vorrichtung zur Durchführung des erfindungsgemäßen Verfahrens mit einem Mikro-Computer;

Fig.1b      ein Prinzipschaltbild eines kapazitiven Wegaufnehmers;

Fig.2      ein Prinzipschaltbild der erfindungsgemäßen Meßvorrichtung, die durch diskrete elektronische Bausteine aufgebaut ist;

Fig.3     ein Diagramm der Spannungsverhältnisse in Abhängigkeit von der Zeit für drei verschiedene Schwingkreiswerte des Wegaufnehmers;

Fig.4a bis 4d     Schaltdiagramme, die die Spannungsverhältnisse in Abhängigkeit von der Zeit am Wegaufnehmer und am Vergleichskondensator (3) darstellen und den Zusammenhang zwischen Ein-und Ausschaltung der Schalter ($S_1$ und $S_2$) darstellen.

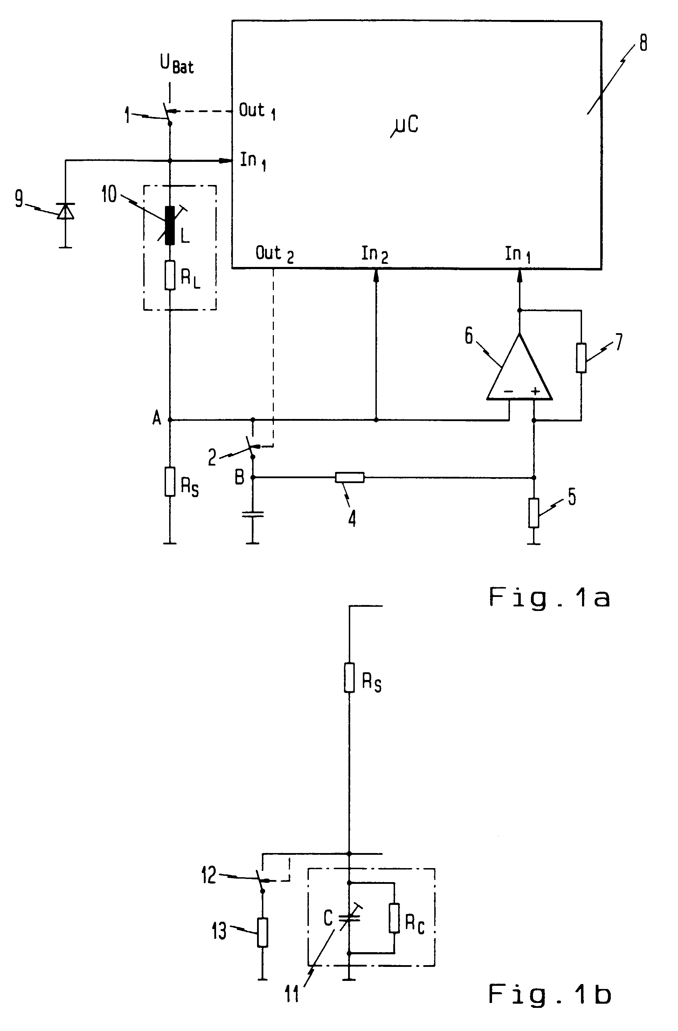

In Fig.1a ist ein Prinzipschaltbild einer Meßvorrichtung gezeigt. In diesem Prinzipschaltbild ist ein erster Schalter 1 ersichtlich, der den Wegaufnehmer 10 im geschlossenen Zustand an die Versorgungsspannung ($U_{Bat}$) legt, wenn er ein Signal vom Ausgang (Out 1) des Mikrocomputers 8 erhält. Der zweite Schalter 2 wird ebenfalls vom Mikrocomputer 8 mit seinem zweiten Ausgang (Out 2) gesteuert und legt das RC-Glied, bestehend aus einem Vergleichskondensator und zwei Widerständen 4,5 an eine Spannung ($U_A$) am Punkt A der Schaltung. Dadurch entsteht an dem Punkt B der Schaltung eine Spannung ($U_B$), deren zeitlicher Verlauf sich nach den Werten der Vergleichskapazität 3 und den Widerständen 4,5 richtet.

Der Mikrocomputer 8 weist drei Eingänge (In 1, In 2, In 3) auf, wobei am Eingang (In 1) die Versorgungsspannung ($U_{Bat}$) liegt, wenn der erste Schalter 1 geschlossen ist. Der zweite Eingang (In 2) mißt den Spannungsverlauf am Punkt A und der dritte Eingang (In 3) mißt die Spannung am Ausgang des Komparators 6.

Es ist äußerst vorteilhaft den Komparator in der gezeigten Weise zu beschalten, da diese Beschaltung das Umschalten im Meßzyklus unterstützt und die Wirkung von Störungen auf dem Meßsignal unterdrückt.

Der Wegsensor 10 setzt sich im vorliegenden Fall aus einer Spule (L) und einem Widerstand $R_L$ zusammen, die beide durch äußere Einflüsse, wie beispielsweise die Temperatur oder das Eintauchen eines Eisenkerns in die Spule (L), Änderungen erfahren.

Anstatt einer Induktivität (L) kann bei der vorliegenden Erfindung auch eine entsprechende veränderbare Kapazität (C) als kapazitiver Wegaufnehmer 11 in die Meßvorrichtung einbezogen werden. Der kapazitive Wegaufnehmer 11 ist in Fig.1b dargestellt. In diesem Falle ist jedoch ein dritter steuerbarer Schalter 12 vorgesehen, der den Kondensator (C) zum Entladen über einen Widerstand 13 an Masse legt.

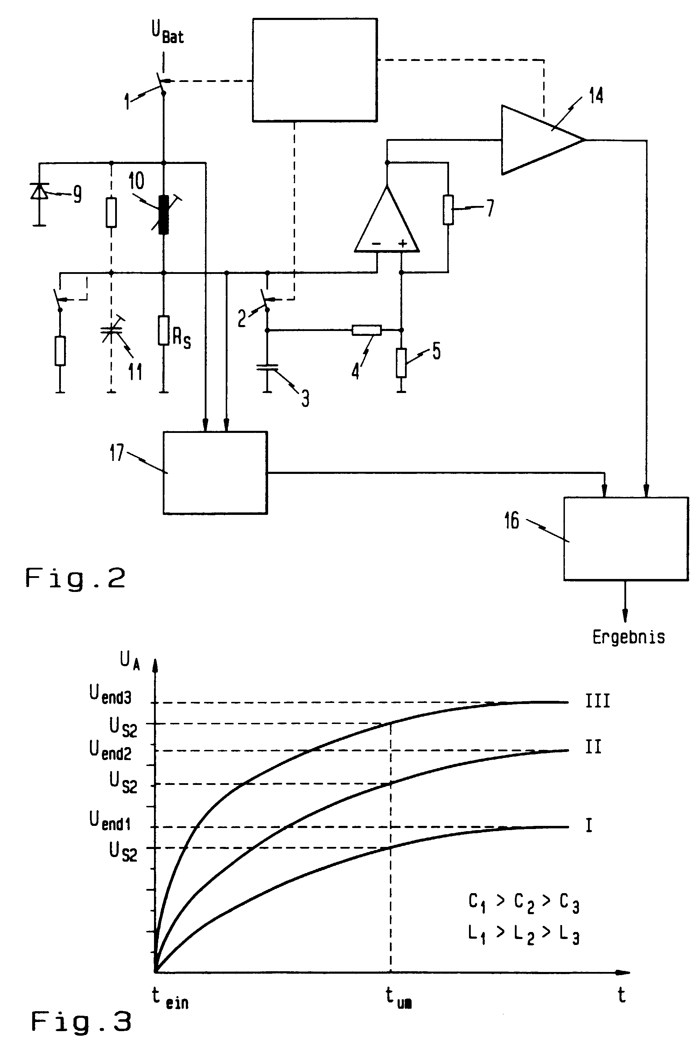

In Fig.3 ist der zeitliche Spannungsverlauf verschiedener Wegaufnehmer dargestellt. Gemessen werden die Spannungen am Punkt A der Schaltung in Fig.1a. Der Endwert (I, II, III) der Spannung am Punkt A ergibt sich aus dem Verhältnis von $R_s$ zu $R_L + R_s$. Für die größte Induktivität bzw. Kapazität stellt sich demgemäß auch der größte Endwert III der Spannung $U_A$ ein. Das bedeutet auch, daß für eine höhere Induktivität bzw. höhere Kapazität ein höherer Schwellenwert der entsprechenden Spannung gemessen wird. Beim Einschalten zum Zeitpunkt $T_{ein}$ ist die Spannung $U_A$ gleich 0 und steigt nach einer Exponential-Funktion bis zu einem gewissen Endwert an, wobei eine größere Induktivität (L) ein langsameres Ansteigen der Spannung am Punkt A bewirkt.

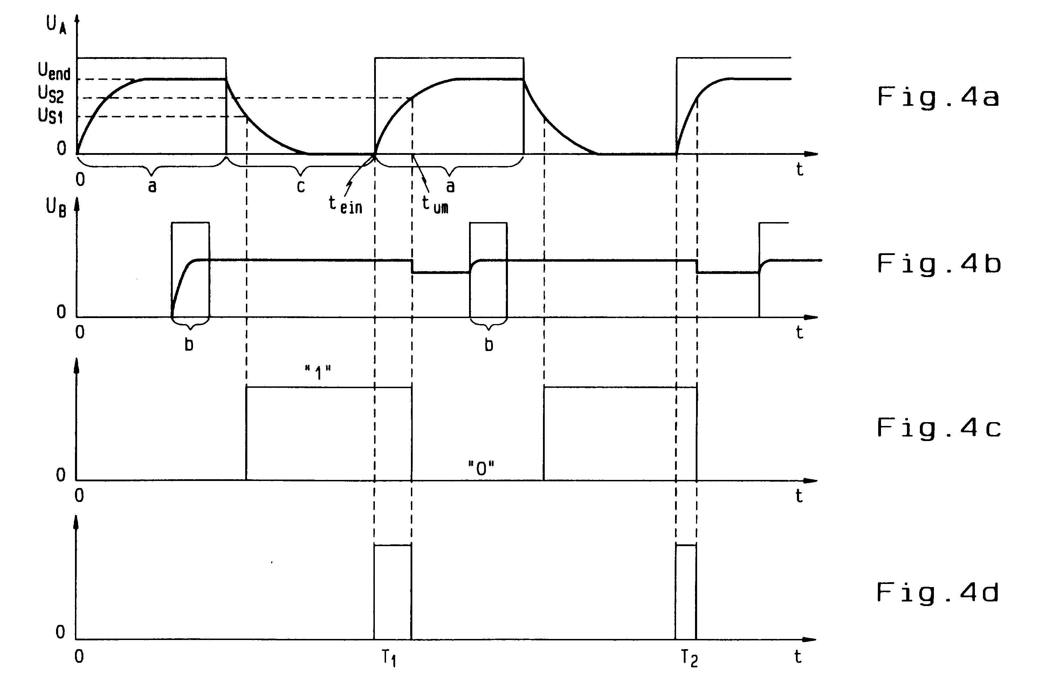

Die Funktionsweise der vorliegenden Erfindung läßt sich am besten anhand der Diagramme in den Figuren 4a - 4d erläutern. Der erfindungsgemäße Meßzyklus unterteilt sich in zwei Abschnitte und zwar in eine sogenannte Initialisierungsphase und in den tatsächlichen Meßvorgang. In Fig.4a ist einerseits der Spannungsverlauf am Punkt A und andererseits die periodischen Rechteckimpulse der Breite (a) Fig.la gemessenen Spannung ($U_A$) aufgetragen. Die Initialisierung ist nur vor der ersten Messung zwingend erforderlich. Jeder Meßvorgang kann dann zur Initialisierung der folgenden Messung herangezogen werden, wenn der zeitliche Abstand zwischen zwei Messungen ausreichend kurz ist. In der Initialisierungs-Phase wird die Spule 10 mit dem ersten steuerbaren Schalter 1 zunächst an die Versorgungsspannung ($U_{Bat}$) zum Zeitpunkt t=O gelegt, worauf die Spannung für eine bestimmte Zeit (t=a) an dem Wegaufnehmer 10 liegt. Während dieser Zeit wird der Wegaufnehmer bis zu einer bestimmten Endspannung ($U_{end}$) während des Zeitintervalls (t=a) aufgeladen. Innerhalb dieses Zeitintervalls wird der zweite Schalter 2 kurzzeitig, verglichen zu t=a, eingeschaltet, wodurch der Kondensator 3 bis zur Sättigung mit der Endspannung ($U_{end}$ aufgeladen wird. Der Wert der Endspannung ($U_{end}$) ist von den Widerstandswerten von $R_L$ und $R_s$ abhängig. Nachdem der zweite Schalter 2 wieder geöffnet wird, nachdem das Zeitintervall (b) abgelaufen ist, entlädt sich der Kondensator 3 über die Widerstände 4 und 5. Die Zeitkonstante dieses RC-Gliedes ist verhältnismäßig groß zu wählen, so daß am Punkt B der Schaltung kein merklicher Spannungsverlust während der Entladephase des Wegaufnehmers zu verzeichnen ist. Da die Widerstände 4 und 5 einen Spannungsteiler darstellen, wird dem positiven Eingang des Komparators 6 eine in diesem Verhältnis verminderte Endspannung ($U_{end}$) zugeführt.

Nachdem sich der Wegaufnehmer im Falle einer Induktivität über die Freilaufdiode 9 entladen hat, ($\Delta$t=c) wird der Schalter 1 erneut zum Zeitpunkt $t_{ein}$ eingeschaltet, worauf sich der Ladevorgang der Spule wiederholt und die Spannung infolge der großen Zeitkonstanten der Vergleichskapazität 3 und der Widerstände 4,5 am Punkt B weiterhin unverändert ansteht. Nachdem der erste Schalter 1 nach Ablauf des Zeitintervalls (a) wieder geöffnet wird, entlädt sich, der Wegaufnehmer während eines Zeitintervalls (c). Sobald die Spannung am Punkt A einen bestimmten Schwellenwert ($U_{S1}$) unterschreitet, gibt der Ausgang des Komparators 6 eine positive Ausgangsspannung ab (s.Fig.4c). Diese positive Ausgangsspannung, die einer logischen "1" gleichgesetzt wird, bleibt so lange bestehen, bis nach Wiedereinschalten des Wegaufnehmers an diesem ein zweiter Schwellenwert ($U_{S2}$) erreicht wird. Nach Erreichen dieses Schwellenwertes ($U_{S2}$) schaltet der Komparator am Ausgang von logisch "1" auf logisch "0". Der Umschaltvorgang geschieht zur Zeit $t_{um}$. Das Zeitintervall von $t_{ein}$ bis $t_{um}$ wird gemessen und mit $T_n$ bezeichnet, wobei $n=1......\infty$ sein kann. Infolge der unterschiedlichen Ausgleichszeiten für verschiedene Werte der Induktivität bzw. Kapazität des Wegaufnehmers ergeben sich somit auch unterschiedliche Werte für die Intervalle $T_1$, $T_2$..... $T_n$.

Durch das erneute Einschalten des zweiten Schalters 2 während des Zeitintervalls (b) wird der Vergleichskondensator 3 ständig wieder aufgeladen und auf den neuesten Stand der zuletzt gemessenen Endspannung, die abhängig ist vom momentanen Wert des $R_L$ am Wegaufnehmer, gebracht.

Für den Fall, daß von einer Messung bis zur nächsten Messung einer im Verhältnis zur Zeitkonstanten an der Schwelle zu große Zeit vergeht, ist vor jedem Messen die Initialisierungsphase erneut durchzuführen.

Die Zeitmessung und Zeitsteuerung wird mittels eines Mikrocomputers 8 durchgeführt. Für die Zeitmessung wird, wie bereits oben erwähnt, das Ausgangssignal des Komparators 6 dem Eingang ($In_3$) des Mikrocomputers 8 zugeführt. Die Zeit zwischen dem Einschalten des ersten Schalters 1 und dem Umschalten des Komparators 6 wird gemessen zu

$$T = T_{um} - T_{ein}.$$

Bei der Lösung der erfindungsgemäß gestellen Aufgabe wird in Fig.2 mit dem zweiten Einschalten des ersten Schalters 1 über eine Logik 15 ein Integrierer 14 gestartet, welcher durch den Komparator 6 wieder abgeschaltet wird. Der Wert des Integrals am Ausgang des Integrierers 14 wird einem Multiplizierer 16 zugeführt, da zusammen aus dem im Dividierer 17 gebildeten Verhältnis aus $In_1$ und $In_2$ das Endergebnis erstellt.

Zur Kompensation von Fehlern durch eine Änderung von $R_L$, die beispielsweise durch Änderung der Umgebungstemperatur oder durch Alterung eintreten kann, werden die Versorgungsspannung ($U_{Bat}$) und der Wert der Endspannung ($U_{end}$) nach jedem Ladevorgang des Wegaufnehmers gemessen und mit der gemessenen Zeit ($T_{end}$) in einem bestimmten Ausgleichsprogramm berücksichtigt, so daß diese Störfaktoren nicht mit in die eigentliche Messung der Zeit konstanten (T) eingehen.

Unter der Voraussetzung, daß die Bauelemente ($R_S$) der Kondensator 3 und die Widerstände 4 und 5 konstant sind, folgt aus bekannten Beziehungen

$$T = L/(R_L + R_S) \times 1n(1 - U_S/U_{end}).$$

Unter der Voraussetzung daß das Argument des natürlichen Logarithmus im wesentlichen konstant ist, ergibt sich also für

$$T = -L/(R_L + R_S) \times k$$

wobei k ein konstanter Faktor ist.

Da aber der ohmsche Widerstand der Induktivität ($R_L$) bzw. $R_C$ temperaturabhängig ist und der Einfluß der Alterung den ohmschen Widerstand verändern kann, muß deren Einfluß kompensiert werden. Für den Fall einer Iduktivität gilt

$$U_{end}/U_{Bat} = R_S/(R_L + R_S).$$

Um den Einfluß von $R_L$ zu kompensieren, werden $U_{end}$ in der Sättigung und $U_{Bat}$ gemessen und mit der gemessenen Zeitkonstante gemäß

$$T = L/R_S \times k.$$

Hieraus ist ersichtlich, daß die gemessene Zeit lediglich von der Induktivität L abhängig ist was wiederum eine Funktion der Meßgröße, d.h., im vorliegenden Fall, des zurückgelegten Weges ist.

Durch die oben erwähnten Maßnahmen ist das Meßergebnis also nur von der veränderlichen Induktivität bzw. Kapazität des Wegaufnehmers abhängig, da der Serienwiderstand ($R_S$) und der ohmsche Widerstand des Wegaufnehmers quasi konstant ist bzw. kompensiert wurde.

Kurzfassung:

Mit der vorliegenden Erfindung wird ein Wegaufnehmer vorgestellt, der sowohl mit einem induktiven (10) - als auch mit einem kapazitiven (11) Sensor ausgestattet sein kann. Erfindungsgemäß wird als Maß für die veränderliche Induktivität bzw. Kapazität ein Zeitintervall (T) gemessen, wobei die Schwankungen des ohmschen Widerstandes des Wegaufnehmers infolge von Temperatureinflüssen bzw. Alterung mit Hilfe eines Korrekturprogramms kompensiert werden, so daß der Wert der Induktivität bzw. Kapazität direkt von der Meßgröße, d.h., dem zurückgelegten Weg des Sensors abhängig ist.

**Bezugszeichenliste**

1    erster Schalter
2    zweiter Schalter
3    Vergleichkondensator
4    Widerstand
5    Widerstand
6    Komparator

7 Hysteresewiderstand
8 Mikro-Computer
9 Freilaufdiode
10 Induktivität
11 Kapazität
12 dritter Schalter
13 Widerstand
14 Integrierer
15 Logik
16 Multiplizierer
17 Dividierer

**Patentansprüche**

1. Verfahren zur Messung der Zeitkonstanten (T) eines elektrischen Wegaufnehmers, bei dem insbesondere die Änderung der Versorgungsspannung ($U_{Bat}$) und der Temperatur kompensiert wird, dadurch gekennzeichnet,

daß eine Reihenschaltung aus dem Wegaufnehmer (10, 11) und einem Meßwiderstand ($R_S$) mittels eines ersten steuerbaren Schalters (1) so lange an die Versorgungsspannung ($U_{Bat}$) gelegt wird, bis eine Endspannung ($U_{end}$) erreicht ist, bei der eine Sättigung vorliegt,
daß diese Endspannung ($U_{end}$) mittels eines zweiten steuerbaren Schalters (2) so lange einer konstanten Kapazität (3) zugeführt wird, bis die Kapazität (3) geladen ist,
daß der zweite steuerbare Schalter (2) daraufhin wieder geöffnet wird und seine mittels eines Spannungsteilers (4, 5) herabgesetzte Kondensatorspannung dem positiven Eingang eines Komparators (6) zugeführt wird,
daß der Komparator die Spannung am Verbindungspunkt (A) zwischen dem Wegaufnehmer (10, 11) und dem Meßwiderstand ($R_s$) mit der herabgesetzten Kondensatorspannung vergleicht und
daß durch Zeitmessungen der Zeit zwischen dem Einschalten des ersten steuerbaren Schalters und einem Umschalten des Komparators (6) eine Zeitdifferenz gewonnen wird, die direkt proportional der zu messenden Größe ist.

2. Verfahren nach Anspruch 1, dadurch gekennzeichnet, daß am positiven Eingang des Komparators (6) mittels des Spannungsteilers (4, 5) eine Schwellenspannung ($U_s$) eingestellt wird.

3. Verfahren nach Anspruch 2, dadurch gekennzeichnet, daß der Wert der Schwellenspannung ($U_s$) in einem Speicher abgespeichert wird.

4. Verfahren nach Anspruch 1, dadurch gekennzeichnet, daß durch abermaliges Öffnen des ersten steuerbaren Schalters (1) nach einer vorbestimmten Zeit der Wegaufnehmer (10, 11) entladen wird, so daß der Komparator (6) bei Erreichen einer bestimmten Schwellenspannung ($U_s$) am negativen Eingang des Komparators (6) eine positive Ausgangsspannung abgibt.

5. Verfahren nach Anspruch 3, dadurch gekennzeichnet, daß der erste steuerbare Schalter (1) zu einem vorgegebenen Zeitpunkt ($T_{ein}$) erneut geschlossen wird, so daß durch den erneuten Anstieg der Spannung am negativen Eingang des Komparators (6) sein Ausgang von logisch "1" auf logisch "o" umschaltet, wenn die Spannung am gemeinsamen Verbindungspunkt (A) zwischen dem Wegaufnehmer (10, 11) und dem Meßwiderstand ($R_s$) den Spannungspegel der abgespeicherten Schwellenspannung ($U_s$) erreicht hat.

6. Verfahren nach einem der vorangegangenen Ansprüche, dadurch gekennzeichnet, daß der Komparator (6) mit einer Hysterese so beschaltet wird, daß sie den Meßvorgang mittels eines Widerstandes (7) unterstützt.

7. Verfahren nach Anspruch 1, dadurch gekennzeichnet, daß der zweite steuerbare Schalter (2) während jeder Phase des Aufladens des Wegaufnehmers (10, 11) erneut eingeschaltet wird, so daß der Wert der Schwellenspannung ($U_s$) aktualisiert wird.

8. Verfahren nach Anspruch 1, dadurch gekennzeichnet, daß die Zeit ($T_1$, $T_2$, $T_n$) zwischen dem Zeitpunkt des Einschaltens ($T_{ein}$) des ersten steuerbaren Schalters (1) und dem Umschalten ($T_{um}$) des Komparators (6) mittels eines Mikrocomputers (8) gemessen wird.

9. Verfahren nach Anspruch 1, dadurch gekennzeichnet, daß die Versorgungsspannung ($U_{Bat}$) und die Endspannung ($U_{end}$) nach dem Aufladevorgang des Wegaufnehmers (10, 11) gemessen und einer Ausgleichsrechnung zugeführt wird.

10. Meßvorrichtung eines elektrischen Wegaufnehmers (10, 11), dessen Meßsignal proportional dem zurückgelegten Weg des Wegaufnehmers ist, mit einer Auswertelektronik, die insbesondere temperatur- und altersbedingte Schwankungen des Wegaufnehmers berücksichtigt, gekennzeichnet durch

- einen ersten elektronisch gesteuerten Schalter (1), der die Versorgungsspannung ($U_{Bat}$) einer Reihenschaltung aus dem Wegaufnehmer (10, 11) und einem Meßwiderstand ($R_s$) zuführt;

- einen zweiten elektronisch gesteuerten Schalter (2), der eine veränderbare Endspannung ($U_{end}$) des Wegaufnehmers (10, 11), bei der Sättigung des Wegaufnehmers aufgetreten ist, einem RC-Glied, bestehend aus zwei Widerständen (4, 5) und einer Kapazität (3), zuführt;
- einen hysteresearmen Komparator (6), dessen positiver Eingang mit dem Mittelpunkt eines aus den zwei Widerständen bestehenden Spannungsteilers (4, 5) verbunden ist; und
- einen Integrator (14), dessen Eingang mit dem Ausgang des Komparators verbunden ist.

11. Meßvorrichtung nach Anspruch 10, dadurch gekennzeichnet, daß die Zeitkonstante des RC-Gliedes, bestehend aus den Widerständen (4, 5) und der Kapazität (3), sehr viel größer ist als die des Wegaufnehmers (10, 11).

12. Meßvorrichtung nach Anspruch 10, dadurch gekennzeichnet, daß der zweite steuerbare Schalter (2) ein FET-Transistor ohne parasitäre Diode ist.

13. Meßvorrichtung nach Anspruch 10, dadurch gekennzeichnet, daß der positive Eingang des Komparators (6) über einen hochohmigen Widerstand (7) mit dem Ausgang des Komparators verbunden ist.

14. Meßvorrichtung nach Anspruch 10, dadurch gekennzeichnet, daß der Wegaufnehmer eine veränderbare Induktivität (L) ist.

15. Meßvorrichtung nach Anspruch 10, dadurch gekennzeichnet, daß der Wegaufnehmer (11) eine veränderbare Kapazität (C) ist.

16. Meßvorrichtung nach einem der Ansprüche 10 bis 15, gekennzeichnet durch einen Mikrocomputer (8), der die Meßvorrichtung steuert.

17. Meßvorrichtung nach einem der Ansprüche 10 bis 15, gekennzeichnet durch diskrete elektronische Bauelemente, die die Steuerung der Meßvorrichtung vornehmen.

**Claims**

1. Method of measuring the time-constant (T) of an electrical displacement transducer, wherein especially the variations of the supply voltage ($U_{Bat}$) and the temperature are compensated, characterised in that a series circuit including the displacement transducer (10, 11) and a measuring resistor ($R_s$) is connected to the supply voltage ($U_{Bat}$) by means of a first controllable switch (1) until a final voltage ($U_{end}$) is achieved at which saturation occurs,

that this final voltage ($U_{end}$) is supplied by means of a second controllable switch (2) to a constant capacitor (3) until the capacitor (3) has been charged,

that said second controllable switch (2) is then opened again whilst its capacitor voltage, which is reduced by means of a voltage divider (4, 5), is supplied to the positive input of a comparator (6),

that said comparator compares the voltage at the connecting point (A) between said displacement transducer (10, 11) and said measuring resistor (($R_s$) against the reduced capacitor voltage, and

that a time difference is produced which is directly proportional to the measurand, by detecting the time elapsing between the actuation of said first controllable switch and the time by which said comparator (6) switches.

2. Method according to Claim 1, characterised in that a threshold voltage ($U_s$) is set at the positive input of said comparator (6) by means of said voltage divider (4, 5).

3. Method according to Claim 2, characterised in that the value of said threshold voltage ($U_s$) is stored in a memory.

4. Method according to Claim 1, characterised in that said displacement transducer (10, 11) is discharged by opening said first controllable switch (1) again after a predetermined period of time so that when a specified threshold voltage (Us) is reached at the negative input of said comparator (6) said comparator (6) issues a positive output voltage.

5. Method according to Claim 3, characterised in that said first controllable switch (1) is closed again at a predetermined point of time ($T_{ein}$) so that due to the repeated increase of the voltage at the negative input of said comparator (6) its output is switched from logic "1" to logic "0" if the voltage at the common connecting point (A) between said displacement transducer (10, 11) and said measuring resistor ($R_s$) has reached the voltage level of said stored threshold voltage ($U_s$).

6. Method according to any of the preceding Claims, characterised in that said comparator (6) is connected with a hysteresis in such a way that the latter will support the measuring process by means of a resistor (7).

7. Method according to Claim 1, characterised in that said second controllable switch (2) is started again during each charging phase of said displacement transducer (2) so as to update the value of said

threshold voltage ($U_s$).

8. Method according to Claim 1, characterised in that the time ($T_1$, $T_2$, $T_n$) between the time by which said first controllable switch (1) ) is actuated ($T_{ein}$) and the time by which said comparator (6) switches ($T_{um}$) is measured by means of a microcomputer (8).

9. Method according to Claim 1, characterised in that the supply voltage ($U_{Bat}$) and the final voltage ($U_{end}$) are measured after the displacement transducer (10, 11) charging operation and the result is transmitted for compensation calculation.

10. Measuring apparatus in an electrical displacement transducer (10, 11) whose measuring signal is proportional to the displacement covered by the displacement transducer, including an electronic analyser system considering especially temperature-induced and age-induced variations of the displacement transducer, characterised by

   - a first electronically controlled switch (1) which supplies the supply voltage ($U_{Bat}$) to a series circuit including said displacement transducer (10, 11) and a measuring resistor ($R_s$);
   - a second electronically controlled switch (2) which supplies a variable final voltage ($U_{end}$) of said displacement transducer (10, 11), at which saturation occurs in the displacement transducer, to an RC circuit consisting of two resistors (4, 5) and a capacitor (3);
   - a low-hysteresis comparator (6) whose positive input is connected to the centre point of a voltage divider (4, 5) consisting of said two resistors; and
   - an integrator (14) whose input is connected to the output of said comparator.

11. Measuring apparatus according to Claim 10, characterised in that the time constant of said RC circuit consisting of said resistors (4, 5) and said capacitor (3) is much greater than the constant of said displacement transducer (10, 11).

12. Measuring apparatus according to Claim 10, characterised in that said second controllable switch (2) is a FET-type transistor without a parasitic diode.

13. Measuring apparatus according to Claim 10, characterised in that the positive input of said comparator (6) is connected via a high-impedance resistor (7) to the output of said comparator.

14. Measuring apparatus according to Claim 10, characterised in that said displacement transducer is a variable inductance (L) element.

15. Measuring apparatus according to Claim 10, characterised in that said displacement transducer is a variable capacitance (C) element.

16. Measuring apparatus according to any of the Claims 10 to 15, characterised by a microcomputer (8) controlling said measuring apparatus.

17. Measuring apparatus according to any of the Claims 10 to 15, characterised by discrete electronic components ensuring the control of the measuring apparatus.

**Revendications**

1. Procédé à mesurer la constante de temps (T) d'un capteur de déplacement électrique, dans lequel en particulier les variations d'une tension d'alimentation ($U_{Bat}$) et la température sont compensées, caractérisé en ce qu'un couplage en série, qui comprend ledit capteur de déplacement (10, 11) et un résisteur de mesure ($R_s$), est relié à la tension d'alimentation moyennant un premier commutateur contrôlable (1) jusqu'à une tension finale ($U_{end}$) est atteinte à laquelle il y a une saturation,

   en ce que cette tension finale ($U_{end}$) est alimentée, moyennant un deuxième commutateur contrôlable (2), à un condensateur constant (3) jusqu'à ce que ledit condensateur (3) est chargé,
   en ce que ledit deuxième commutateur contrôlable (2) est ensuite ouvert encore pendant que sa tension du condensateur, qui est réduite moyennant un diviseur de tension (4, 5), est alimentée à l'entrée positive d'un comparateur (6),
   en ce que ledit comparateur compare la tension au point de connexion (A) entre ledit capteur de déplacement (10, 11) et ledit résisteur de ($R_s$) avec la tension de condensateur réduite, et
   en ce qu'une différence de temps est produite, qui est directement proportionnelle à la variable à mesurer, par mesure du temps entre la mise en circuit du premier commutateur contrôlable et la commutation du comparateur(6).

2. Procédé selon la revendication 1, caractérisé en ce qu'une tension de seuil ($U_s$) est réglée à l'entrée positive dudit (6) moyennant ledit diviseur de tension (4, 5).

3. Procédé selon la revendication 2, caractérisé en ce que la valeur de ladite tension de seuil ($U_s$) est mise en mémoire.

4. Procédé selon la revendication 1, caractérisé en ce que ledit capteur de déplacement (10, 11) est déchargé en ouvrant encore ledit commutateur contrôlable (1) après un intervalle déterminé, de façon que quand tension de seuil ($U_s$) spécifiée est atteinte à l'entrée négative dudit comparateur (6), ce comparateur (6) émet une tension de sortie positive.

5. Procédé selon la revendication 3, caractérisé en ce que ledit premier commutateur contrôlable (1) est fermé de nouveau à un point de temps déterminé ($T_{ein}$) de façon qu'en vertu de l'augmentation répétée de la tension à l'entrée négative dudit comparateur (6) sa sortie est commutée de "1" logique à "0" logique si la tension au point de connexion commun (A) entre ledit capteur de déplacement (10, 11) et ledit résisteur de mesure ($R_s$) atteigne le niveau de tension de la tension de seuil ($U_s$) mise en mémoire.

6. Procédé selon une quelconque des revendications précédentes, caractérisé en ce que ledit comparateur (6) est relié à une hystérèse de façon qu'elle assiste l'opération de mesure moyennant un résisteur (7).

7. Procédé selon la revendication 1, caractérisé en ce que ledit deuxième commutateur contrôlable (2) est mis de nouveau en circuit au cours de chaque phase de charge dudit capteur de déplacement (2) afin de mettre à jour la valeur de ladite tension de seuil ($U_s$).

8. Procédé selon la revendication 1, caractérisé en ce que le temps ($T_1$, $T_2$, $T_n$) entre le temps auquel ledit premier commutateur contrôlable (1) est mis en circuit ($T_{ein}$) et le temps auquel ledit comparateur (6) commute ($T_{um}$) est mesuré moyennant un micro-ordinateur (8).

9. Procédé selon la revendication 1, caractérisé en ce que la tension d'alimentation ($U_{Bat}$) et la tension finale ($U_{end}$) sont mesurées après l'opération de chargement du capteur de déplacement (10, 11), et en ce que le résultat est transmis pour le calcul de la compensation.

10. Appareil à mesurer dans un capteur de déplacement (10, 11) électrique dont le signal de mesure est proportionnel au déplacement subi par ledit capteur de déplacement, qui comprend un système d'analyse électronique qui prend des variations du capteur de déplacement en considération, en particulier des variations dues à la température et au vieillissement, caractérisé par

- un premier commutateur électroniquement contrôlable (1), qui alimente un couplage en série en tension d'alimentation ($U_{Bat}$), qui comprend capteur de déplacement (10, 11) et un résisteur de mesure ($R_s$);

- un deuxième commutateur électroniquement contrôlable (2), qui alimente une tension finale variable ($U_{end}$) dudit capteur de déplacement (10, 11), à laquelle il y a une saturation dans le capteur de déplacement, à un circuit R-C qui comprend deux résisteurs (4, 5) et un condensateur (3);

- un comparateur (6) à basse hystérèse, dont l'entrée positive est reliée au centre d'un diviseur de tension (4, 5) formé par lesdits deux résisteurs; et

- un intégrateur (14) dont l'entrée est reliée à la sortie dudit comparateur.

11. Appareil à mesurer selon la revendication 10, caractérisé en ce que la constante dudit circuit R-C formé par lesdits résisteurs (4, 5) et ledit condensateur (3) est beaucoup plus grande que la constante de temps dudit capteur de déplacement (10, 11).

12. Appareil à mesurer selon la revendication 10, caractérisé en ce que ledit deuxième commutateur contrôlable (2) est un transistor à effet de champ sans diode parasitaire.

13. Appareil à mesurer selon la revendication 10, caractérisé en ce que l'entrée positive dudit comparateur (6) est reliée, via un résisteur de haute valeur ohmique (7), à la sortie dudit comparateur.

14. Appareil à mesurer selon la revendication 10, caractérisé en ce que ledit capteur de déplacement est un élément à résistance inductive (L).

15. Appareil à mesurer selon la revendication 10, caractérisé en ce que ledit capteur de déplacement est un élément à capacité variable (C).

16. Appareil à mesurer selon une quelconque des revendications 10 à 15, caractérisé par un micro-ordinateur (8) qui contrôle l'appareil à mesurer.

17. Appareil à mesurer selon une quelconque des revendications 10 à 15, caractérisé par des éléments électroniques discrets qui réalisent le contrôle de l'appareil à mesurer.

Fig.1a

Fig.1b

Fig.2

$C_1 > C_2 > C_3$
$L_1 > L_2 > L_3$

Fig.3

Fig.4a

Fig.4b

Fig.4c

Fig.4d

EP 0 561 054 B1